# EUROPEAN PATENT APPLICATION

(11) **EP 4 498 373 A1**
(43) Date of publication of application: **29.01.2025**
(21) Application number: 23922074.2
(22) Date of filing: 22.02.2023
(51) Int. Cl.: G11C 11/419

(54) **READ-WRITE CIRCUIT, READ-WRITE METHOD, AND MEMORY**

(30) Priority: 13.02.2023 CN 202310106292
(71) Applicant: CXMT Corporation, Hefei, Anhui 230601 (CN)
(72) Inventor: WANG, Jia, Hefei, Anhui 230601 (CN)
(74) Representative: Gulde & Partner
(86) International application number: PCT/CN2023/077731
(87) International publication number: WO 2024/168943

(57) **Abstract**

Embodiments of the present disclosure provide a read/write circuit, a read/write method, and a memory. The read/write circuit includes: a write driver circuit, configured to: precharge a data line, and write to-be-written data into the data line; and a control circuit, when in a mask write mode, the control circuit being configured to control the write driver circuit to stop precharging the data line after data read and before data write, and when not in the mask write mode, the control circuit being configured to control the write driver circuit to precharge the data line before data write.

## Description

### CROSS-REFERENCE TO RELATED APPLICATIONS

The present disclosure is based on Chinese Patent Application No. 202310106292.6, filed on February 13, 2023, and entitled "READ/WRITE CIRCUIT, READ/WRITE METHOD, AND MEMORY", and claims priority to the Chinese Patent Application, which is incorporated herein by reference in its entirety.

### TECHNICAL FIELD

The present disclosure relates to the field of semiconductor technologies, and in particular, to a read/write circuit, a read/write method, and a memory.

### BACKGROUND

A dynamic random access memory (DRAM) is a semiconductor memory, and a main operation principle thereof is that an amount of charge stored in a capacitor is utilized to represent whether a binary bit is 1 or 0. In the DRAM, a data line is generally precharged to a supply voltage (VCC) before data read starts and after data read ends.

A mask write mode includes a read operation (Pseudo Read) and a write operation (Write Back). In a related technology, the data line is also precharged to the supply voltage between pseudo read and write back, causing a current waste.

### SUMMARY

Embodiments of the present disclosure provide a read/write circuit, a read/write method, and a memory, to save current when in a mask write mode, and increase a data write speed when in the mask write mode.

According to a first aspect, an embodiment of the present disclosure provides a read/write circuit. The read/write circuit includes:
a write driver circuit, configured to: precharge a data line, and write to-be-written data into the data line; and
a control circuit, when in a mask write mode, the control circuit being configured to control the write driver circuit to stop precharging the data line after data read and before data write, and when not in the mask write mode, the control circuit being configured to control the write driver circuit to precharge the data line before data write.

In some embodiments, the control circuit includes a first logic circuit and a second logic circuit.

The first logic circuit is configured to: receive an amplifier enable signal and a mask write flag signal, and perform a logical operation on the amplifier enable signal and the mask write flag signal to generate a first intermediate signal.

The second logic circuit is configured to: receive a read enable signal and the first intermediate signal, and perform a logical operation on the read enable signal and the first intermediate signal to generate a precharge signal.

The mask write flag signal is configured to indicate whether the read/write circuit is in the mask write mode, and the precharge signal is configured to control whether the write driver circuit precharges the data line.

In some embodiments, the read/write circuit is in the mask write mode when the mask write flag signal is in a first level state, so that the precharge signal controls the write driver circuit to stop precharging the data line after data read and before data write; or
the read/write circuit is not in the mask write mode when the mask write flag signal is in a second level state, so that the precharge signal controls the write driver circuit to precharge the data line before data write.

In some embodiments, the read/write circuit further includes a read driver circuit.

The read driver circuit is configured to amplify data on the data line. The amplifier enable signal is configured to control a power supply to provide a supply voltage to the read driver circuit during data read.

In some embodiments, the first logic circuit includes a first NOT gate, a first NAND gate, and a second NOT gate.

An input terminal of the first NOT gate is configured to receive the mask write flag signal, and an output terminal of the first NOT gate is connected to a second input terminal of the first NAND gate.

A first input terminal of the first NAND gate is configured to receive the amplifier enable signal, an output terminal of the first NAND gate is connected to an input terminal of the second NOT gate, and an output terminal of the second NOT gate is configured to output the first intermediate signal.

In some embodiments, the second logic circuit includes a latch circuit.

A first input terminal of the latch circuit is configured to receive the read enable signal, a second input terminal of the latch circuit is configured to receive the first intermediate signal, and an output terminal of the latch circuit is configured to output the precharge signal.

In some embodiments, the second logic circuit further includes a first pulse generation circuit and a second pulse generation circuit.

An input terminal of the first pulse generation circuit is configured to: receive the read enable signal, generate a first pulse based on a rising edge of the read enable signal, and provide the first pulse to the first input terminal of the latch circuit.

An input terminal of the second pulse generation circuit is configured to: receive the first intermediate signal, generate a second pulse based on a falling edge of the first intermediate signal, and provide the second pulse to the second input terminal of the latch circuit.

In some embodiments, the first pulse generation circuit includes a third NOT gate, a first delay circuit, and a second NAND gate.

An input terminal of the third NOT gate is configured to receive the read enable signal, an output terminal of the third NOT gate is connected to an input terminal of the first delay circuit, an output terminal of the first delay circuit is connected to a second input terminal of the second NAND gate, a first input terminal of the second NAND gate is configured to receive the read enable signal, and an output terminal of the second NAND gate serves as an output terminal of the first pulse generation circuit and is connected to the first input terminal of the latch circuit.

In some embodiments, the second pulse generation circuit includes a fourth NOT gate, a second delay circuit, and a first NOR gate.

An input terminal of the fourth NOT gate is configured to receive the first intermediate signal, an output terminal of the fourth NOT gate is connected to an input terminal of the second delay circuit, an output terminal of the second delay circuit is connected to a second input terminal of the first NOR gate, a first input terminal of the first NOR gate is configured to receive the first intermediate signal, and an output terminal of the first NOR gate serves as an output terminal of the second pulse generation circuit and is connected to the second input terminal of the latch circuit.

In some embodiments, the latch circuit includes a third NAND gate and a fourth NAND gate.

A first input terminal of the third NAND gate is connected to the output terminal of the first pulse generation circuit, and a second input terminal of the third NAND gate is connected to an output terminal of the fourth NAND gate.

A first input terminal of the fourth NAND gate is connected to an output terminal of the third NAND gate, a second input terminal of the fourth NAND gate is connected to the output terminal of the second pulse generation circuit, and the output terminal of the third NAND gate serves as the output terminal of the latch circuit to output the precharge signal.

In some embodiments, the first level state is a high level state, and the second level state is a low level state.

In some embodiments, the write driver circuit includes a driver circuit and a precharge circuit.

The driver circuit is configured to write the to-be-written data into the data line based on a write control signal.

The precharge circuit is configured to precharge the data line based on the precharge signal.

In some embodiments, the driver circuit includes a first driver circuit and a second driver circuit, and the data line includes a global data line and a complementary global data line.

The first driver circuit is configured to write the to-be-written data into the global data line based on the write control signal.

The second driver circuit is configured to write the to-be-written data into the complementary global data line based on the write control signal.

In some embodiments, the first driver circuit includes a first pull-up circuit and a first pull-down circuit.

The first pull-up circuit is configured to pull up a potential of the global data line based on the to-be-written data and the write control signal.

The first pull-down circuit is configured to pull down the potential of the global data line based on the to-be-written data.

In some embodiments, the first pull-up circuit includes a fifth NAND gate and a first P-type transistor, and the first pull-down circuit includes a fifth NOT gate and a first N-type transistor.

A first input terminal of the fifth NAND gate is configured to receive the to-be-written data, a second input terminal of the fifth NAND gate is configured to receive the write control signal, and an output terminal of the fifth NAND gate is connected to a gate terminal of the first P-type transistor.

An input terminal of the fifth NOT gate is configured to receive the to-be-written data, and an output terminal of the fifth NOT gate is connected to a gate terminal of the first N-type transistor.

A second terminal of the first P-type transistor is connected to a supply voltage terminal, a second terminal of the first N-type transistor is connected to a ground terminal, and both a first terminal of the first P-type transistor and a first terminal of the first N-type transistor are connected to the global data line.

In some embodiments, the second driver circuit includes a second pull-up circuit and a second pull-down circuit.

The second pull-up circuit is configured to pull up a potential of the complementary global data line based on the to-be-written data.

The second pull-down circuit is configured to pull down the potential of the complementary global data line based on the to-be-written data and the write control signal.

In some embodiments, the second pull-up circuit includes a sixth NOT gate, a seventh NOT gate, and a second P-type transistor, and the second pull-down circuit includes an eighth NOT gate, a third NOR gate, and a second N-type transistor.

An input terminal of the sixth NOT gate is configured to receive the to-be-written data, an output terminal of the sixth NOT gate is connected to an input terminal of the seventh NOT gate, and an output terminal of the seventh NOT gate is connected to a gate terminal of the second P-type transistor.

An input terminal of the eighth NOT gate is configured to receive the write control signal, an output terminal of the eighth NOT gate is connected to a second input terminal of the third NOR gate, a first input terminal of the third NOR gate is connected to the output terminal of the sixth NOT gate, and an output terminal of the third NOR gate is connected to a gate terminal of the second N-type transistor.

A second terminal of the second P-type transistor is connected to the supply voltage terminal, a second terminal of the second N-type transistor is connected to the ground terminal, and both a first terminal of the second P-type transistor and a first terminal of the second N-type transistor are connected to the complementary global data line.

In some embodiments, the precharge circuit includes a ninth NOT gate, a tenth NOT gate, a third P-type transistor, a fourth P-type transistor, and a fifth P-type transistor.

An input terminal of the ninth NOT gate is configured to receive the precharge signal, an output terminal of the ninth NOT gate is connected to an input terminal of the tenth NOT gate, an output terminal of the tenth NOT gate is connected to a gate terminal of the third P-type transistor, a second terminal of the third P-type transistor is connected to the global data line, and a first terminal of the third P-type transistor is connected to the complementary global data line.

Gate terminals of both the fourth P-type transistor and the fifth P-type transistor are connected to the output terminal of the tenth NOT gate, a second terminal of the fourth P-type transistor is connected to the supply voltage terminal, a first terminal of the fourth P-type transistor is connected to the global data line, a second terminal of the fifth P-type transistor is connected to the supply voltage terminal, and a first terminal of the fifth P-type transistor is connected to the complementary global data line.

In some embodiments, the data line includes the global data line and the complementary global data line, and the write driver circuit includes a second AND gate, a second NOR gate, a first P-type transistor, a fifth NOT gate, a first N-type transistor, a ninth NOT gate, a tenth NOT gate, a third P-type transistor, a sixth NOT gate, a fourth NOR gate, a second P-type transistor, an eighth NOT gate, a third NOR gate, and a second N-type transistor.

A first input terminal of the second AND gate is configured to receive the to-be-written data, a second input terminal of the second AND gate is configured to receive the write control signal, an output terminal of the second AND gate is connected to a first input terminal of the second NOR gate, an input terminal of the ninth NOT gate is configured to receive the precharge signal, an output terminal of the ninth NOT gate is separately connected to a second input terminal of the second NOR gate, an input terminal of the tenth NOT gate, and a first input terminal of the fourth NOR gate, an output terminal of the second NOR gate is connected to a gate terminal of the first P-type transistor, an input terminal of the fifth NOT gate is configured to receive the to-be-written data, an output terminal of the fifth NOT gate is connected to a gate terminal of the first N-type transistor, a second terminal of the first P-type transistor is connected to the supply voltage terminal, and a second terminal of the first N-type transistor is connected to the ground terminal.

An input terminal of the sixth NOT gate is configured to receive the to-be-written data, an output terminal of the sixth NOT gate is separately connected to a second input terminal of the fourth NOR gate and a first input terminal of the third NOR gate, an output terminal of the fourth NOR gate is connected to a gate terminal of the second P-type transistor, an input terminal of the eighth NOT gate is configured to receive the write control signal, an output terminal of the eighth NOT gate is connected to a second input terminal of the third NOR gate, an output terminal of the third NOR gate is connected to a gate terminal of the second N-type transistor, a second terminal of the second P-type transistor is connected to the supply voltage terminal, and a second terminal of the second N-type transistor is connected to the ground terminal.

An output terminal of the tenth NOT gate is connected to a gate terminal of the third P-type transistor, a first terminal of the first P-type transistor, a first terminal of the first N-type transistor, and a second terminal of the third P-type transistor are all connected to the global data line, and a first terminal of the second P-type transistor, a first terminal of the second N-type transistor, and a first terminal of the third P-type transistor are all connected to the complementary global data line.

According to a second aspect, an embodiment of the present disclosure provides a read/write method. The method includes the steps as follows.

A data line is precharged by a write driver circuit, and to-be-written data is written into the data line.

When in a mask write mode, the write driver circuit is controlled, by a control circuit, to stop precharging the data line after data read and before data write, and when not in the mask write mode, the write driver circuit is controlled, by the control circuit, to precharge the data line before data write.

According to a third aspect, an embodiment of the present disclosure provides a memory. The memory includes the read/write circuit according to any one embodiment of the first aspect.

The embodiments of the present disclosure provide a read/write circuit, a read/write method, and a memory. The read/write circuit includes: a write driver circuit, configured to: precharge a data line, and write to-be-written data into the data line; and a control circuit, when in a mask write mode, the control circuit being configured to control the write driver circuit to stop precharging the data line after data read and before data write, and when not in the mask write mode, the control circuit being configured to control the write driver circuit to precharge the data line before data write. In this way, the control circuit may determine, based on a current operation mode, whether to control the write driver circuit to stop precharging the data line. Only when the current operation mode is the mask write mode, the control circuit controls the write driver circuit to stop precharging the data line after data read and before data write. This can save current when in the mask write mode, and can increase a data write speed when in the mask write mode, thereby improving memory performance.

### BRIEF DESCRIPTION OF DRAWINGS

FIG. 1 is a schematic diagram of structural composition of a data write circuit;
FIG. 2 is a schematic diagram of signal timing of a data write circuit;
FIG. 3 is a schematic diagram 1 of structural composition of a read/write circuit according to an embodiment of the present disclosure;
FIG. 4 is a schematic diagram 2 of structural composition of a read/write circuit according to an embodiment of the present disclosure;
FIG. 5 is a schematic diagram 3 of structural composition of a read/write circuit according to an embodiment of the present disclosure;
FIG. 6 is a schematic diagram 1 of structural composition of a first logic circuit according to an embodiment of the present disclosure;
FIG. 7 is a schematic diagram 2 of structural composition of a first logic circuit according to an embodiment of the present disclosure;
FIG. 8 is a schematic diagram 1 of structural composition of a second logic circuit according to an embodiment of the present disclosure;
FIG. 9 is a schematic diagram 2 of structural composition of a second logic circuit according to an embodiment of the present disclosure;
FIG. 10 is a schematic diagram 3 of structural composition of a second logic circuit according to an embodiment of the present disclosure;
FIG. 11 is a schematic diagram of structural composition of a first pulse generation circuit according to an embodiment of the present disclosure;
FIG. 12 is a schematic diagram of structural composition of a second pulse generation circuit according to an embodiment of the present disclosure;
FIG. 13 is a schematic diagram 1 of signal timing according to an embodiment of the present disclosure;
FIG. 14 is a schematic diagram 2 of signal timing according to an embodiment of the present disclosure;
FIG. 15 is a schematic diagram 1 of a detailed structure of a write driver circuit according to an embodiment of the present disclosure;
FIG. 16 is a schematic diagram 2 of a detailed structure of a write driver circuit according to an embodiment of the present disclosure;
FIG. 17A is a schematic diagram 1 of a detailed structure of a control circuit according to an embodiment of the present disclosure;
FIG. 17B is a schematic diagram 2 of a detailed structure of a control circuit according to an embodiment of the present disclosure;
FIG. 18 is a schematic diagram 3 of signal timing according to an embodiment of the present disclosure;
FIG. 19 is a schematic diagram of a detailed structure of a read/write conversion circuit according to an embodiment of the present disclosure;
FIG. 20 is a schematic diagram of a detailed structure of a read driver circuit according to an embodiment of the present disclosure;
FIG. 21 is a schematic flowchart of a read/write method according to an embodiment of the present disclosure; and
FIG. 22 is a schematic diagram of structural composition of a memory according to an embodiment of the present disclosure.

### DESCRIPTION OF EMBODIMENTS

The following clearly describes the technical solutions in the embodiments of the present disclosure with reference to the accompanying drawings in the embodiments of the present disclosure. It may be understood that a specific embodiment described herein is merely intended to explain related disclosure, but is not intended to limit the present disclosure. In addition, it should be further noted that, for ease of description, only a part related to the related disclosure is shown in the accompanying drawings.

Unless otherwise defined, all technical and scientific terms included herein have the same meanings as those generally understood by a person skilled in the technical field of the present disclosure. The terms included herein are merely intended to describe the embodiments of the present disclosure, and are not intended to limit the present disclosure.

The following description relates to "some embodiments" describing a subset of all the possible embodiments. However, it may be understood that "some embodiments" may be the same or different subsets of all the possible embodiments, and may be combined with each other in the case of no conflict.

It should be noted that the term "first\second\third" in the embodiments of the present disclosure is merely intended to distinguish between similar objects, and does not represent specific sorting for the objects. It may be understood that "first\second\third" may be interchanged for a specific sequence or order if allowed, so that the embodiments of the present disclosure described herein can be implemented in a sequence other than those shown or described herein.

Before the embodiments of the present disclosure are further described in detail, nouns and terms in the embodiments of the present disclosure are first described. The nouns and the terms in the embodiments of the present disclosure are applicable to the following explanations:
dynamic random access memory (DRAM);
error check and correction (ECC);
P-type metal oxide semiconductor field effect transistor/P-type transistor (Positive channel Metal Oxide Semiconductor field effect transistor, PMOS transistor);
N-type metal oxide semiconductor field effect transistor/N-type transistor (Negative channel Metal Oxide Semiconductor field effect transistor, NMOS transistor);
local data line (Io);
complementary local data line (IoN);
global data line (Yio),
complementary global data line (YioN);
sense amplifier (SA).

It may be understood that a mask write mode includes a read operation and a write operation, that is, a process of the mask write mode is to read data first, then replace a part of bits in the readout data, and re-write the data obtained after the replacement into a memory after ECC verification. For a semiconductor memory having no ECC function, the read operation is not required. For a semiconductor memory including an ECC function, the read operation is required during mask write.

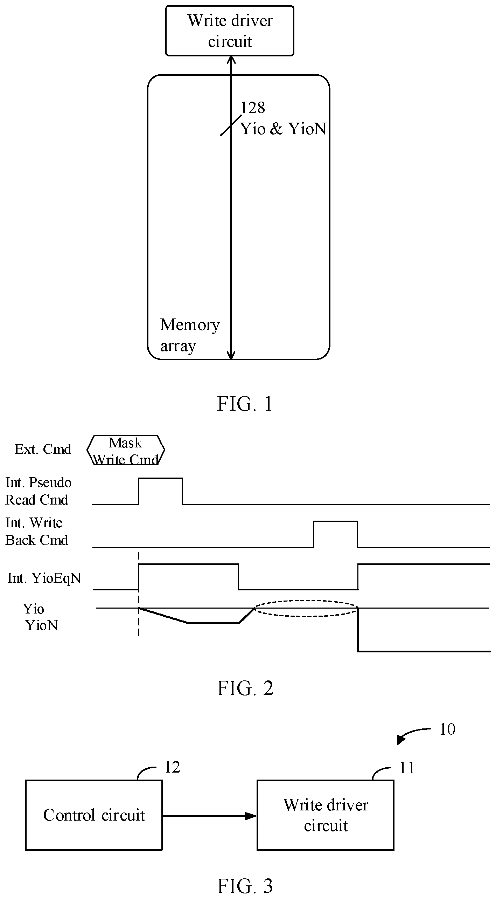

For example, FIG. 1 is a schematic diagram of structural composition of a data write circuit. As shown in FIG. 1, the data write circuit includes a write driver circuit and a memory array. The write driver circuit herein may be specifically a write driver circuit of 2nd SA & Yio in a DRAM, and there are 128 data lines Yio & YioN between the write driver circuit and the memory array, to implement a data write operation.

Herein, for 2nd SA & Yio in the DRAM, Yio is generally precharged to a supply voltage (VCC) before read starts and after read ends. In addition, whether Yio needs to be precharged between write operations may be controlled through a test mode signal. For mask write, mask write is an operation including pseudo read and write back. Pseudo read is to read data from a memory cell to an error check and correction (ECC) circuit for error check and correction, but the read data is not read out of the memory. Write back is to replace partial data that is read during pseudo read and then re-write the data into an original memory cell. In a related technology, Yio also needs to be precharged to VCC between pseudo read and write back. For details, reference is made to FIG. 2, which is a schematic diagram of signal timing of a data write circuit. As shown in FIG. 2, a mask write operation may be performed after an external command (Ext.Cmd), namely, a mask write command (Mask Write Cmd), is received. The mask write command includes a read command (namely, Int. Pseudo Read Cmd) and a write command (namely, Int. Write Back Cmd). When Int. Pseudo Read Cmd is at the high level, a precharge signal (Int. YioEqN) is at a high level, and a data line (Yio/YioN) is not precharged. After data read and before data write, Int. YioEqN is changed from the high level to a low level, and Yio/YioN starts to be precharged until Yio/YioN is precharged to VCC, as represented by a dashed-line circle in FIG. 2. In addition, Int. Pseudo Read Cmd, Int. Write Back Cmd, and Int. YioEqN are all internal commands or internal signals obtained after decoding.

Based on this, the embodiments of the present disclosure provide a read/write circuit. The read/write circuit includes: a write driver circuit, configured to: precharge a data line, and write to-be-written data into the data line; and a control circuit, when in a mask write mode, the control circuit being configured to control the write driver circuit to stop precharging the data line after data read and before data write, and when not in the mask write mode, the control circuit being configured to control the write driver circuit to precharge the data line before data write. In this way, the control circuit may determine, based on a current operation mode, whether to control the write driver circuit to stop precharging the data line. Only when the current operation mode is the mask write mode, the control circuit controls the write driver circuit to stop precharging the data line after data read and before data write. This can save current when in the mask write mode, and can increase a data write speed when in the mask write mode, thereby improving memory performance.

The embodiments of the present disclosure are described below in detail with reference to the accompanying drawings.

In an embodiment of the present disclosure, FIG. 3 is a schematic diagram 1 of structural composition of a read/write circuit according to an embodiment of the present disclosure. As shown in FIG. 3, the read/write circuit 10 includes:
a write driver circuit 11, configured to: precharge a data line, and write to-be-written data into the data line; and
a control circuit 12, when in a mask write mode, the control circuit 12 being configured to control the write driver circuit 11 to stop precharging the data line after data read and before data write, and when not in the mask write mode, the control circuit 12 being configured to control the write driver circuit 11 to precharge the data line before data write.

It should be noted that in this embodiment of the present disclosure, the data line into which the write driver circuit 11 writes the to-be-written data is a global data line Yio and a complementary global data line YioN. The read/write circuit 10 provided in this embodiment is configured to read and write data. Specifically, the data line does not need to be precharged when in the mask write mode, to save current. When in the mask write mode, a read operation needs to be performed before data write. When not in the mask write mode, data may be written after being read, or data may be written continuously, or data may be written after being refreshed. That is, when not in the mask write mode, a data read operation is not necessarily performed before data write. This is not specifically limited herein.

It should be further noted that when in the mask write mode, the control circuit 12 in the read/write circuit 10 controls the write driver circuit 11 not to precharge the data line after data read and before data write. This can save current when in the mask write mode. For example, when in the mask write mode, Yio/YioN is not precharged after data read and before data write. An LPDDR4 product is taken as an example. Approximately 3% of mask write current can be saved.

It should be further noted that, after "1" is read, a voltage on the global data line Yio is 1, and a potential on the complementary global data line YioN is less than or equal to VCC-250 mV. If "0" needs to be written back into the data lines during write back, and when the data lines need to be precharged, the potentials on the data lines both return to VCC after precharge. In this case, the voltage is changed from the supply voltage to 0 (namely, VCC---->0). When the data lines do not need to be precharged, the voltage of the complementary global data line YioN is changed from the supply voltage minus 250 millivolts (mV) to 0 ((VCC-250 mV)---->0). Therefore, when in the mask write mode, a data write speed can be further increased if Yio/YioN is not precharged after data read and before data write. In addition, it should be noted that 250 mV is a split voltage difference between Yio/YioN during data read, that is, during the read operation, the voltage difference can be correctly identified and amplified by a sense amplifier only when the voltage difference between Yio/YioN reaches the value (split voltage difference).

In some embodiments, for the read/write circuit 10, in addition to the write driver circuit 11 and the control circuit 12, the read/write circuit may further include a read/write conversion circuit and a read driver circuit (not shown in FIG. 3). The read/write conversion circuit is configured to: write data on the data line into a local data line and a complementary local data line, or read data on a local data line and a complementary local data line to the data line. The read driver circuit is configured to amplify data on the data line.

Herein, the read/write conversion circuit may write data on the global data line (Yio) and the complementary global data line (YioN) into the local data line (Io) and the complementary local data line (IoN) based on a write control signal (WrEn); or may read data on the local data line (Io) and the complementary local data line (IoN) to the global data line (Yio) and the complementary global data line (YioN) based on a read enable signal (RdEn).

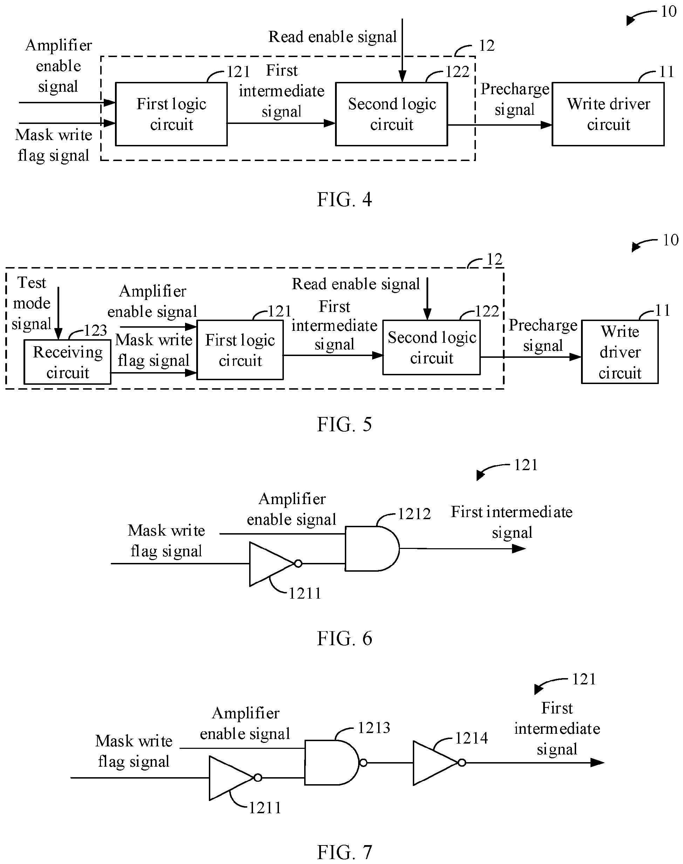

Further, for the control circuit 12, in some embodiments, reference is made to FIG. 4, which is a schematic diagram 2 of structural composition of a read/write circuit according to an embodiment of the present disclosure. As shown in FIG. 4, the control circuit 12 includes a first logic circuit 121 and a second logic circuit 122.

The first logic circuit 121 is configured to: receive an amplifier enable signal and a mask write flag signal, and perform a logical operation on the amplifier enable signal and the mask write flag signal to generate a first intermediate signal.

The second logic circuit 122 is configured to: receive a read enable signal and the first intermediate signal, and perform a logical operation on the read enable signal and the first intermediate signal to generate a precharge signal.

The mask write flag signal is configured to indicate whether the read/write circuit 10 is in the mask write mode, and the precharge signal is configured to control whether the write driver circuit 11 precharges the data line. In addition, the amplifier enable signal is configured to control a power supply to provide a supply voltage to the read driver circuit during data read.

It should be noted that, as shown in FIG. 4, an input terminal of the first logic circuit 121 is configured to receive the amplifier enable signal (YsaEn) and the mask write flag signal (Mask Write Flag), an output terminal of the first logic circuit 121 is configured to output the first intermediate signal, and the output terminal of the first logic circuit 121 is connected to the second logic circuit 122. An input terminal of the second logic circuit 122 is configured to receive the read enable signal and the first intermediate signal, and an output terminal of the second logic circuit 122 is configured to output the precharge signal (YioEqN). That is, the control circuit 12 receives the amplifier enable signal and the read enable signal, indicates, by introducing the mask write flag signal, whether the read/write circuit 10 is in the mask write mode, so as to control whether the write driver circuit 11 precharges the data line, and can determine an end time of a read operation in the mask write mode through the read enable signal.

In some embodiments, the read/write circuit 10 is in the mask write mode when the mask write flag signal is in a first level state, so that the precharge signal controls the write driver circuit 11 to stop precharging the data line after data read and before data write; or
the read/write circuit 10 is not in the mask write mode, that is, the read/write circuit does not enter the mask write mode, when the mask write flag signal is in a second level state, so that the precharge signal controls the write driver circuit 11 to precharge the data line before data write.

It should be noted that in this embodiment of the present disclosure, the first level state may be a high level state, and the second level state may be a low level state. Alternatively, the first level state may be a low level state, and the second level state may be a high level state.

That is, in this embodiment of the present disclosure, the mask write flag signal may have two level states: the high level state and the low level state. That the first level state is a high level state and the second level state is a low level state is taken as an example. The read/write circuit 10 is in the mask write mode when the mask write flag signal is in the high level state. The read/write circuit 10 is not in the mask write mode when the mask write flag signal is in the low level state.

Further, in some embodiments, based on the read/write circuit 10 shown in FIG. 4, FIG. 5 is a schematic diagram 3 of structural composition of a read/write circuit according to an embodiment of the present disclosure. As shown in FIG. 5, the control circuit 12 may further include a receiving circuit 123.

The receiving circuit 123 is configured to: receive a test mode signal, and generate the mask write flag signal based on the test mode signal; determine that the mask write flag signal is in the first level state if the test mode signal indicates that the mask write mode is entered; or determine that the mask write flag signal is in the second level state if the test mode signal indicates that the mask write mode is not entered.

It should be noted that, the receiving circuit 123 may generate the mask write flag signal based on the test mode signal after the test mode signal is received, and input the mask write flag signal into the first logic circuit 121. Then, the first logic circuit 121 inputs the generated first intermediate signal into the second logic circuit 122. The second logic circuit 122 generates the precharge signal, and provides the precharge signal to the write driver circuit 11.

It should be further noted that, after the test mode signal is received, the receiving circuit 123 may generate the mask write flag signal in a different level state based on a mode in which the memory is located. The mask write flag signal is in the high level state when the mask write mode is entered. The mask write flag signal is in the low level state when not in the mask write mode. In this way, after a level state of the mask write flag signal is determined, the level state (e.g., the low level state or the high level state) of the precharge signal is controlled based on the mask write flag signal in a different level state, to control whether the write driver circuit 11 precharges the data line. It may be understood that the state of the mask write flag signal is related to the mode in which the memory is located. That is, when in different modes, the mask write flag signal may be in different level states, to adapt to different modes to control the level state of the precharge signal.

In this way, in this embodiment of the present disclosure, the mask write flag signal is introduced, and the level state of the precharge signal is controlled based on the mask write flag signal, to stop precharging the data line based on the precharge signal when in the mask write mode. This can save current when in the mask write mode, and can increase a data write speed when in the mask write mode.

It should be further noted that in this embodiment of the present disclosure, the mask write flag signal may be represented by Mask Write Flag. For example, a specific implementation of this embodiment of the present disclosure is described in detail through the following example: When the mask write flag signal is in the high level state (that is, Mask Write Flag="High"), the read/write circuit 10 is in the mask write mode, and the precharge signal is in the high level state, so that the write driver circuit 11 stops precharging the data line.

Further, for the first logic circuit 121, in a possible implementation, reference is made to FIG. 6, which is a schematic diagram 1 of structural composition of a first logic circuit according to an embodiment of the present disclosure. As shown in FIG. 6, the first logic circuit 121 may include a first NOT gate 1211 and a first AND gate 1212.

An input terminal of the first NOT gate 1211 is configured to receive the mask write flag signal, and an output terminal of the first NOT gate 1211 is connected to a second input terminal of the first AND gate 1212.

A first input terminal of the first AND gate 1212 is configured to receive the amplifier enable signal, and an output terminal of the first AND gate 1212 is configured to output the first intermediate signal.

It should be noted that the first logic circuit 121 may be formed by connecting the first NOT gate 1211 and the first AND gate 1212. A NOT logical operation is performed on the mask write flag signal by the first NOT gate 1211 to obtain an inverted mask write flag signal. Then, an AND logical operation is performed on the inverted mask write flag signal and the amplifier enable signal by the first AND gate 1212 to obtain the first intermediate signal, and the first intermediate signal is provided to the second logic circuit 122.

In another possible implementation, FIG. 7 is a schematic diagram 2 of structural composition of a first logic circuit according to an embodiment of the present disclosure. As shown in FIG. 7, the first logic circuit 121 may include a first NOT gate 1211, a first NAND gate 1213, and a second NOT gate 1214.

An input terminal of the first NOT gate 1211 is configured to receive the mask write flag signal, and an output terminal of the first NOT gate 1211 is connected to a second input terminal of the first NAND gate 1213.

A first input terminal of the first NAND gate 1213 is configured to receive the amplifier enable signal, an output terminal of the first NAND gate 1213 is connected to an input terminal of the second NOT gate 1214, and an output terminal of the second NOT gate 1214 is configured to output the first intermediate signal.

It should be further noted that the first logic circuit 121 may alternatively be formed by connecting the first NOT gate 1211, the first NAND gate 1213, and the second NOT gate 1214. The first AND gate may be equivalently replaced by the first NAND gate 1213 and the second NOT gate 1214. Herein, a NOT logical operation is performed on the mask write flag signal by the first NOT gate 1211 to obtain an inverted mask write flag signal. Then, a NAND logical operation is performed on the inverted mask write flag signal and the amplifier enable signal by the first NAND gate 1213 to obtain a second intermediate signal. Then, a NOT logical operation is performed on the second intermediate signal by the second NOT gate 1214 to obtain the first intermediate signal, and the first intermediate signal is provided to the second logic circuit.

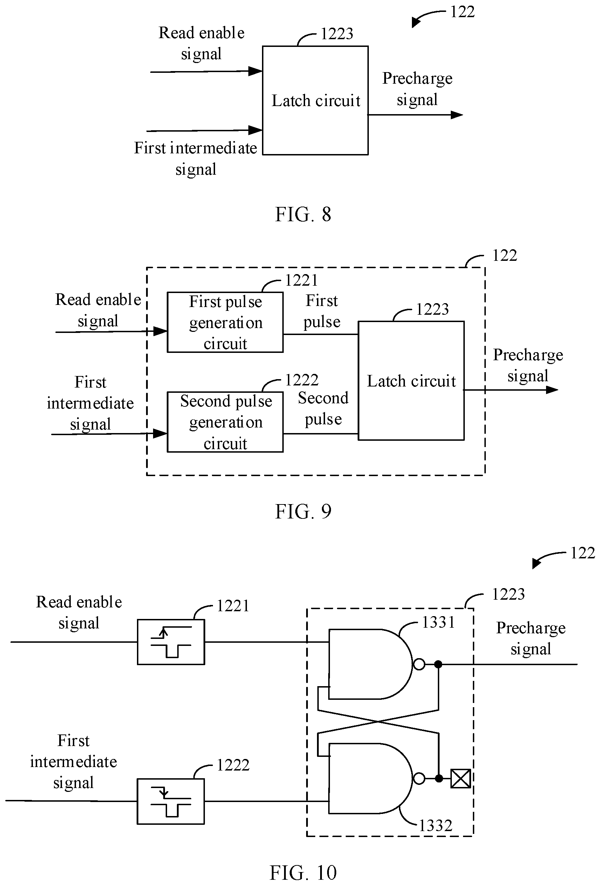

Further, for the second logic circuit 122, in a possible implementation, reference is made to FIG. 8, which is a schematic diagram 1 of structural composition of a second logic circuit according to an embodiment of the present disclosure. As shown in FIG. 8, the second logic circuit 122 may include a latch circuit 1223.

A first input terminal of the latch circuit 1223 is configured to receive the read enable signal, a second input terminal of the latch circuit 1223 is configured to receive the first intermediate signal, and an output terminal of the latch circuit 1223 is configured to output the precharge signal.

In another possible implementation, FIG. 9 is a schematic diagram 2 of structural composition of a second logic circuit according to an embodiment of the present disclosure. As shown in FIG. 9, the second logic circuit 122 may include a first pulse generation circuit 1221, a second pulse generation circuit 1222, and a latch circuit 1223.

An input terminal of the first pulse generation circuit 1221 is configured to: receive the read enable signal, generate a first pulse based on a rising edge of the read enable signal, and provide the first pulse to a first input terminal of the latch circuit 1223.

An input terminal of the second pulse generation circuit 1222 is configured to: receive the first intermediate signal, generate a second pulse based on a falling edge of the first intermediate signal, and provide the second pulse to a second input terminal of the latch circuit 1223.

It should be noted that, as shown in FIG. 9, an output terminal of the first pulse generation circuit 1221 is connected to the first input terminal of the latch circuit 1223, and an output terminal of the second pulse generation circuit 1222 is connected to the second input terminal of the latch circuit 1223.

It should be further noted that in this embodiment of the present disclosure, the first pulse generation circuit 1221 is a rising edge-triggered pulse generation circuit, and the second pulse generation circuit 1222 is a falling edge-triggered pulse generation circuit. In this embodiment of the present disclosure, the pulse signals generated by the first pulse generation circuit 1221 and the second pulse generation circuit 1222 each may be a 7g narrow pulse signal. 7g represents a pulse width, and may be delay time of seven logic gate circuits. In addition, in this embodiment of the present disclosure, a pulse width of a pulse signal may be determined based on delay time. When the delay time is relatively short, the pulse signals generated by the first pulse generation circuit 1221 and the second pulse generation circuit 1222 each may be a narrow pulse signal compared with an input signal. This is not specifically limited herein.

It should be further noted that in this embodiment of the present disclosure, the second logic circuit 122 may only include the latch circuit 1223 because both the read enable signal and the first intermediate signal are pulse signals. In this case, the precharge signal can be obtained by performing latch processing on the input read enable signal and the input first intermediate signal by the latch circuit 1223. Alternatively, because pulse widths of the read enable signal and the first intermediate signal are large, the second logic circuit 122 may include the first pulse generation circuit 1221, the second pulse generation circuit 1222, and the latch circuit 1223 together. In this case, the read enable signal is configured to generate a new smaller pulse signal by the first pulse generation circuit 1221, and the first intermediate signal is configured to generate a new smaller pulse signal by the second pulse generation circuit 1222. Then, the precharge signal may also be obtained by performing latch processing by the latch circuit 1223.

In this way, the first intermediate signal may be obtained by the first logic circuit 121 based on the mask write flag signal and the amplifier enable signal. Then, the precharge signal may be obtained by performing logical processing on the read enable signal and the first intermediate signal by the second logic circuit 122. In this way, there is an association relationship between the precharge signal and the mask write flag signal. Therefore, when in the mask write mode, the write driver circuit 11 is controlled, based on the level state of the precharge signal, to stop precharging the data line, so as to save current.

Further, in some embodiments, for the second logic circuit 122, reference is made to FIG. 10, which is a schematic diagram 3 of structural composition of a second logic circuit according to an embodiment of the present disclosure. As shown in FIG. 10, the latch circuit 1223 may include a third NAND gate 1331 and a fourth NAND gate 1332.

A first input terminal of the third NAND gate 1331 is connected to the output terminal of the first pulse generation circuit 1221, and a second input terminal of the third NAND gate 1331 is connected to an output terminal of the fourth NAND gate 1332.

A first input terminal of the fourth NAND gate 1332 is connected to an output terminal of the third NAND gate 1331, a second input terminal of the fourth NAND gate 1332 is connected to the output terminal of the second pulse generation circuit 1222, and the output terminal of the third NAND gate 1331 serves as the output terminal of the latch circuit 1223 to output the precharge signal.

It should be noted that the third NAND gate 1331 and the fourth NAND gate 1332 form the latch circuit 1223. The first input terminal of the third NAND gate 1331 receives a narrow pulse signal generated based on the read enable signal, the second input terminal of the fourth NAND gate 1332 receives a narrow pulse signal generated based on the first intermediate signal, and the output terminal of the third NAND gate 1331 outputs the precharge signal.

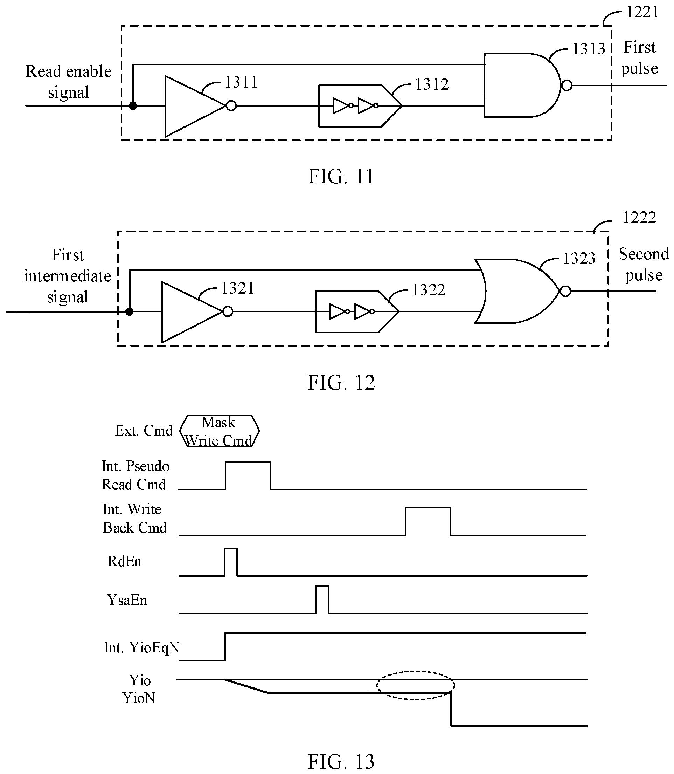

In some embodiments, for the first pulse generation circuit 1221, reference is made to FIG. 11, which is a schematic diagram of structural composition of a first pulse generation circuit according to an embodiment of the present disclosure. As shown in FIG. 11, the first pulse generation circuit 1221 includes a third NOT gate 1311, a first delay circuit 1312, and a second NAND gate 1313. An input terminal of the third NOT gate 1311 is configured to receive the read enable signal, an output terminal of the third NOT gate 1311 is connected to an input terminal of the first delay circuit 1312, an output terminal of the first delay circuit 1312 is connected to a second input terminal of the second NAND gate 1313, a first input terminal of the second NAND gate 1313 is configured to receive the read enable signal, and an output terminal of the second NAND gate 1313 serves as the output terminal of the first pulse generation circuit 1221 and is connected to the first input terminal of the latch circuit.

Herein, a NOT logical operation is performed on the read enable signal by the third NOT gate 1311 to obtain an inverted read enable signal. Then, delay processing is performed on the inverted read enable signal by the first delay circuit 1312 to obtain a delayed read enable signal. Then, a NAND logical operation is performed on the read enable signal and the delayed read enable signal by the second NAND gate 1313 to obtain a narrow pulse signal, namely, a first pulse, and the narrow pulse signal is provided to the first input terminal of the latch circuit.

In some embodiments, for the second pulse generation circuit 1222, reference is made to FIG. 12, which is a schematic diagram of structural composition of a second pulse generation circuit according to an embodiment of the present disclosure. As shown in FIG. 12, the second pulse generation circuit 1222 includes a fourth NOT gate 1321, a second delay circuit 1322, and a first NOR gate 1323. An input terminal of the fourth NOT gate 1321 is configured to receive the first intermediate signal, an output terminal of the fourth NOT gate 1321 is connected to an input terminal of the second delay circuit 1322, an output terminal of the second delay circuit 1322 is connected to a second input terminal of the first NOR gate 1323, a first input terminal of the first NOR gate 1323 is configured to receive the first intermediate signal, and an output terminal of the first NOR gate 1323 serves as the output terminal of the second pulse generation circuit 1222 and is connected to the second input terminal of the latch circuit.

Herein, a NOT logical operation is performed on the first intermediate signal by the fourth NOT gate 1321 to obtain an inverted first intermediate signal. Then, delay processing is performed on the inverted first intermediate signal by the second delay circuit 1322 to obtain a delayed first intermediate signal. Then, a NOR logical operation is performed on the first intermediate signal and the delayed first intermediate signal by the first NOR gate 1323 to obtain another narrow pulse signal, namely, a second pulse, and the narrow pulse signal is provided to the second input terminal of the latch circuit.

In some embodiments, both the first delay circuit and the second delay circuit may include an even quantity of NOT gates connected in series. Because the first delay circuit includes an even quantity of NOT gates, only delay processing is performed on the inverted read enable signal, and a level state of the signal is not changed. Similarly, because the second delay circuit includes an even quantity of NOT gates, only delay processing is performed on the inverted first intermediate signal, and a level state of the signal is not changed.

For example, although the first delay circuit 1312 in FIG. 11 and the second delay circuit 1322 in FIG. 12 each include two NOT gates connected in series, the first delay circuit and the second delay circuit each may include four NOT gates connected in series, or may include six or eight NOT gates connected in series. This is not specifically limited in this embodiment of the present disclosure. In addition, delay time between an input signal and an output signal of each of the first delay circuit and the second delay circuit is related to a specific quantity of NOT gates in the delay circuit. The delay time between the input signal and the output signal of the delay circuit varies with the quantity of NOT gates in the delay circuit. Specifically, the quantity of NOT gates in the delay circuit may be increased when a pulse width of a pulse signal that needs to be generated is large, to increase the delay time; or the quantity of NOT gates in the delay circuit may be reduced when a pulse width of a pulse signal that needs to be generated is small, to reduce the delay time. In this way, in this embodiment of the present disclosure, the specific quantity of NOT gates in the delay circuit may be determined based on the pulse width of the pulse signal that needs to be generated.

FIG. 13 is a schematic diagram 1 of signal timing according to an embodiment of the present disclosure, and is specifically a schematic diagram of signal timing when the mask write flag signal is in the high level state (that is, Mask Write Flag=1). As shown in FIG. 13, a mask write operation may be performed after Mask Write Cmd is received. In this embodiment of the present disclosure, YsaEn and RdEn are further received at this time. RdEn is also changed from the low level state to the high level state when Int. Pseudo Read Cmd is changed from the low level state to the high level state. In this case, Int. YioEqN is also changed from the low level state to the high level state, and there is a need to stop precharging Yio/YioN. Int. YioEqN continues to be in the high level state when YsaEn is changed from the high level state to the low level state. In this case, precharging to Yio/YioN is stopped continuously. That is, when in the mask write mode, Yio/YioN is not precharged after data read and before data write, as represented by a dashed-line circle in FIG. 13.

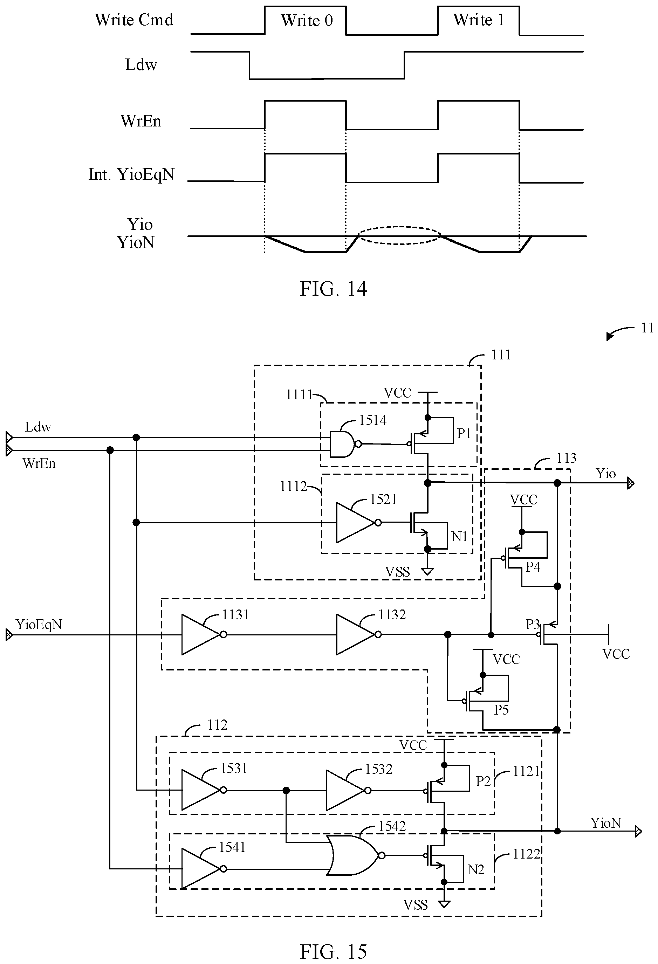

FIG. 14 is a schematic diagram 2 of signal timing according to an embodiment of the present disclosure, and is specifically a schematic diagram of signal timing when the mask write flag signal is in the low level state (that is, Mask Write Flag=0), that is, during normal read/write. As shown in FIG. 14, an operation of writing 0 and 1 is performed after Write Cmd is received. Write Cmd is in the high level state when the operation of writing 0 and 1 is performed. In this case, WrEn and Int. YioEqN are also in the high level state. Before data write, Yio/YioN starts to be precharged when Int. YioEqN is in the low level state, until Yio/YioN is precharged to VCC, as represented by a dashed-line circle in FIG. 14. Precharging to Yio/YioN is stopped when Int. YioEqN is in the high level state.

Herein, it can be learned from comparison between FIG. 13 and FIG. 14 that the level state of Mask Write Flag is changed, to control Int. YioEqN. In this way, the mask write flag signal is introduced to control the level state of the precharge signal. Therefore, when in the mask write mode, precharging to the global data line/complementary global data line is stopped after data read and before data write. This can save current when in the mask write mode, and can increase a data write speed when in the mask write mode.

In some embodiments, the write driver circuit may include a driver circuit and a precharge circuit. The driver circuit is configured to write the to-be-written data into the data line based on a write control signal. The precharge circuit is configured to precharge the data line based on the precharge signal.

It should be noted that in this embodiment of the present disclosure, the write driver circuit has a precharge function and a drive function, and may include the driver circuit and the precharge circuit. The to-be-written data (Ldw) may be further written into Yio/YioN by the driver circuit after Yio/YioN is precharged by the precharge circuit.

In a specific embodiment, for the write driver circuit 11, reference is made to FIG. 15. In some embodiments, the write driver circuit 11 may include a first driver circuit 111, a second driver circuit 112, and a precharge circuit 113.

The first driver circuit 111 is configured to write the to-be-written data into the global data line Yio based on the write control signal.

The second driver circuit 112 is configured to write the to-be-written data into the complementary global data line YioN based on the write control signal.

The precharge circuit 113 is configured to precharge the data line based on the precharge signal.

Further, the first driver circuit 111 may include a pull-up circuit and a pull-down circuit. Specifically, in some embodiments, as shown in FIG. 15, the first driver circuit 111 includes a first pull-up circuit 1111 and a first pull-down circuit 1112.

The first pull-up circuit 1111 is configured to pull up a potential of the global data line based on the to-be-written data and the write control signal.

The first pull-down circuit 1112 is configured to pull down the potential of the global data line based on the to-be-written data.

It should be noted that output terminals of both the first pull-up circuit 1111 and the first pull-down circuit 1112 are connected to the global data line. A function of the first pull-up circuit 1111 is to pull up the potential of the global data line to VCC, that is, write "1" into the global data line. A function of the first pull-down circuit 1112 is to pull down the potential of the global data line to VSS, that is, write "0" into the global data line.

It should be further noted that in this embodiment of the present disclosure, VCC represents a supply voltage terminal configured to provide the high level (the high level/the high level state in this embodiment refers to logic "1"). In addition, a voltage provided by the supply voltage terminal is also denoted as VCC. VSS represents a ground terminal (or referred to as a ground power supply) configured to provide the low level (the low level/the low level state in this embodiment refers to logic "0"). In addition, a voltage provided by the ground terminal is also denoted as VSS.

In some embodiments, as shown in FIG. 15, the first pull-up circuit 1111 includes a fifth NAND gate 1514 and a first P-type transistor (P1), and the first pull-down circuit 1112 includes a fifth NOT gate 1521 and a first N-type transistor (N1).

A first input terminal of the fifth NAND gate 1514 is configured to receive the to-be-written data, a second input terminal of the fifth NAND gate 1514 is configured to receive the write control signal, and an output terminal of the fifth NAND gate 1514 is connected to a gate terminal of the first P-type transistor (P1).

An input terminal of the fifth NOT gate 1521 is configured to receive the to-be-written data, and an output terminal of the fifth NOT gate 1521 is connected to a gate terminal of the first N-type transistor (N1).

A second terminal of the first P-type transistor (P1) is connected to the supply voltage terminal, a second terminal of the first N-type transistor (N1) is connected to the ground terminal, and both a first terminal of the first P-type transistor (P1) and a first terminal of the first N-type transistor (N1) are connected to the global data line.

It should be noted that, as shown in FIG. 15, an input terminal of the first pull-up circuit 1111 is the input terminal of the fifth NAND gate 1514, an output terminal of the first pull-up circuit 1111 is the first terminal of the first P-type transistor (P1), an input terminal of the first pull-down circuit 1112 is the input terminal of the fifth NOT gate 1521, and an output terminal of the first pull-down circuit 1112 is the first terminal of the first N-type transistor (N1).

It should be further noted that the second terminal of the first P-type transistor (P1) may be a source connected to the supply voltage terminal, the first terminal of the first P-type transistor (P1) may be a drain connected to the global data line, the second terminal of the first N-type transistor (N1) may be a source connected to the ground terminal, and the first terminal of the first N-type transistor (N1) may be a drain connected to the global data line.

Further, the second driver circuit 112 may also include a pull-up circuit and a pull-down circuit. Specifically, in some embodiments, as shown in FIG. 15, the second driver circuit 112 includes a second pull-up circuit 1121 and a second pull-down circuit 1122.

The second pull-up circuit 1121 is configured to pull up a potential of the complementary global data line based on the to-be-written data.

The second pull-down circuit 1122 is configured to pull down the potential of the complementary global data line based on the to-be-written data and the write control signal.

It should be noted that output terminals of both the second pull-up circuit 1121 and the second pull-down circuit 1122 are connected to the complementary global data line. A function of the second pull-up circuit 1121 is to pull up the potential of the complementary global data line to VCC, so that the potential of the complementary global data line is "1", that is, write "1" into the complementary global data line. A function of the second pull-down circuit 1122 is to pull down the potential of the complementary global data line to VSS, so that the potential of the complementary global data line is "0", that is, write "0" into the complementary global data line.

In some embodiments, as shown in FIG. 15, the second pull-up circuit 1121 includes a sixth NOT gate 1531, a seventh NOT gate 1532, and a second P-type transistor (P2), and the second pull-down circuit 1122 includes an eighth NOT gate 1541, a third NOR gate 1542, and a second N-type transistor (N2).

An input terminal of the sixth NOT gate 1531 is configured to receive the to-be-written data, an output terminal of the sixth NOT gate 1531 is connected to an input terminal of the seventh NOT gate 1532, and an output terminal of the seventh NOT gate 1532 is connected to a gate terminal of the second P-type transistor (P2).

An input terminal of the eighth NOT gate 1541 is configured to receive the write control signal, an output terminal of the eighth NOT gate 1541 is connected to a second input terminal of the third NOR gate 1542, a first input terminal of the third NOR gate 1542 is connected to the output terminal of the sixth NOT gate 1531, and an output terminal of the third NOR gate 1542 is connected to a gate terminal of the second N-type transistor (N2).

A second terminal of the second P-type transistor (P2) is connected to the supply voltage terminal, a second terminal of the second N-type transistor (N2) is connected to the ground terminal, and both a first terminal of the second P-type transistor (P2) and a first terminal of the second N-type transistor (N2) are connected to the complementary global data line.

It should be noted that, as shown in FIG. 15, an input terminal of the second pull-up circuit 1121 is the input terminal of the sixth NOT gate 1531, an output terminal of the second pull-up circuit 1121 is the first terminal of the second P-type transistor (P2), an input terminal of the second pull-down circuit 1122 is the input terminal of the eighth NOT gate 1541, and an output terminal of the second pull-down circuit 1122 is the first terminal of the second N-type transistor (N2).

It should be further noted that the second terminal of the second P-type transistor (P2) may be a source connected to the supply voltage terminal, the first terminal of the second P-type transistor (P2) may be a drain connected to the complementary global data line, the second terminal of the second N-type transistor (N2) may be a source connected to the ground terminal, and the first terminal of the second N-type transistor (N2) may be a drain connected to the complementary global data line.

Further, for the precharge circuit 113, as shown in FIG. 15, in some embodiments, the precharge circuit 113 includes a ninth NOT gate 1131, a tenth NOT gate 1132, a third P-type transistor (P3), a fourth P-type transistor (P4), and a fifth P-type transistor (P5).

An input terminal of the ninth NOT gate 1131 is configured to receive the precharge signal, an output terminal of the ninth NOT gate 1131 is connected to an input terminal of the tenth NOT gate 1132, an output terminal of the tenth NOT gate 1132 is connected to a gate terminal of the third P-type transistor (P3), a second terminal of the third P-type transistor (P3) is connected to the global data line, and a first terminal of the third P-type transistor (P3) is connected to the complementary global data line.

Gate terminals of both the fourth P-type transistor (P4) and the fifth P-type transistor (P5) are connected to the output terminal of the tenth NOT gate 1132, a second terminal of the fourth P-type transistor (P4) is connected to the supply voltage terminal, a first terminal of the fourth P-type transistor (P4) is connected to the global data line, a second terminal of the fifth P-type transistor (P5) is connected to the supply voltage terminal, and a first terminal of the fifth P-type transistor (P5) is connected to the complementary global data line.

It should be noted that whether to precharge the Yio/YioN may be controlled based on the level state of the precharge signal. The third P-type transistor (P3), the fourth P-type transistor (P4), and the fifth P-type transistor (P5) are all turned on when the precharge signal is in the low level state. Because the second terminals of both the fourth P-type transistor (P4) and the fifth P-type transistor (P5) are connected to VCC, Yio connected to the fourth P-type transistor (P4) is charged to VCC, and YioN connected to the fifth P-type transistor (P5) is also charged to VCC. The third P-type transistor (P3), the fourth P-type transistor (P4), and the fifth P-type transistor (P5) are not turned on when the precharge signal is in the high level state. In this case, Yio and YioN are not precharged.

It should be further noted that the second terminal of the fourth P-type transistor (P4) may be a source connected to the supply voltage terminal, the first terminal of the fourth P-type transistor (P4) may be a drain connected to Yio, the second terminal of the fifth P-type transistor (P5) may be a source connected to the supply voltage terminal, and the first terminal of the fifth P-type transistor (P5) may be a drain connected to YioN.

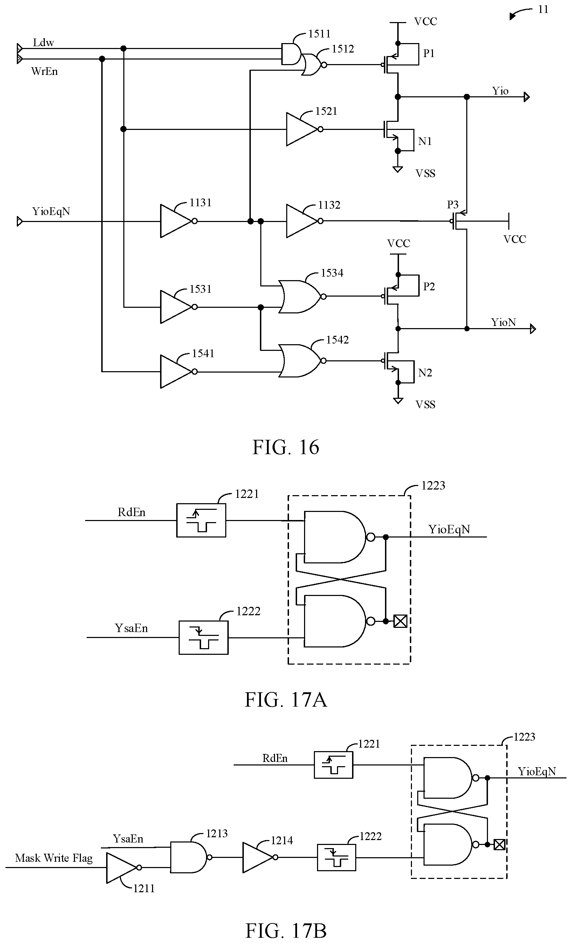

In some other embodiments, FIG. 16 is a schematic diagram 2 of a detailed structure of a write driver circuit according to an embodiment of the present disclosure. As shown in FIG. 16, the write driver circuit 11 may include a second AND gate 1511, a second NOR gate 1512, a first P-type transistor (P1), a fifth NOT gate 1521, a first N-type transistor (N1), a ninth NOT gate 1131, a tenth NOT gate 1132, a third P-type transistor (P3), a sixth NOT gate 1531, a fourth NOR gate 1534, a second P-type transistor (P2), an eighth NOT gate 1541, a third NOR gate 1542, and a second N-type transistor (N2).

A first input terminal of the second AND gate 1511 is configured to receive the to-be-written data, a second input terminal of the second AND gate 1511 is configured to receive the write control signal, an output terminal of the second AND gate 1511 is connected to a first input terminal of the second NOR gate 1512, an input terminal of the ninth NOT gate 1131 is configured to receive the precharge signal, an output terminal of the ninth NOT gate 1131 is separately connected to a second input terminal of the second NOR gate 1512, an input terminal of the tenth NOT gate 1132, and a first input terminal of the fourth NOR gate 1534, an output terminal of the second NOR gate 1512 is connected to a gate terminal of the first P-type transistor (P1), an input terminal of the fifth NOT gate 1521 is configured to receive the to-be-written data, an output terminal of the fifth NOT gate 1521 is connected to a gate terminal of the first N-type transistor (N1), a second terminal of the first P-type transistor (P1) is connected to the supply voltage terminal, and a second terminal of the first N-type transistor (N1) is connected to the ground terminal.

An input terminal of the sixth NOT gate 1531 is configured to receive the to-be-written data, an output terminal of the sixth NOT gate 1531 is separately connected to a second input terminal of the fourth NOR gate 1534 and a first input terminal of the third NOR gate 1542, an output terminal of the fourth NOR gate 1534 is connected to a gate terminal of the second P-type transistor (P2), an input terminal of the eighth NOT gate 1541 is configured to receive the write control signal, an output terminal of the eighth NOT gate 1541 is connected to a second input terminal of the third NOR gate 1542, an output terminal of the third NOR gate 1542 is connected to a gate terminal of the second N-type transistor (N2), a second terminal of the second P-type transistor (P2) is connected to the supply voltage terminal, and a second terminal of the second N-type transistor (N2) is connected to the ground terminal.

An output terminal of the tenth NOT gate 1132 is connected to a gate terminal of the third P-type transistor (P3), a first terminal of the first P-type transistor (P1), a first terminal of the first N-type transistor (N1), and a second terminal of the third P-type transistor (P3) are all connected to the global data line, and a first terminal of the second P-type transistor (P2), a first terminal of the second N-type transistor (N2), and a first terminal of the third P-type transistor (P3) are all connected to the complementary global data line.

An embodiment of the present disclosure provides a read/write circuit. The read/write circuit includes a write driver circuit and a control circuit. The control circuit may determine, based on a current operation mode, whether to control the write driver circuit to stop precharging a data line. Only when the current operation mode is a mask write mode, the control circuit controls the write driver circuit to stop precharging the data line after data read and before data write. This can save current when in the mask write mode, and can increase a data write speed when in the mask write mode, thereby improving memory performance.

In another embodiment of the present disclosure, FIG. 17A is a schematic diagram 1 of a detailed structure of a control circuit according to an embodiment of the present disclosure. As shown in FIG. 17A, the control circuit may include a first pulse generation circuit 1221, a second pulse generation circuit 1222, and a latch circuit 1223. An input terminal of the first pulse generation circuit 1221 is configured to receive a read enable signal (RdEn), an output terminal of the first pulse generation circuit 1221 is connected to a first input terminal of the latch circuit 1223, an input terminal of the second pulse generation circuit 1222 is configured to receive an amplifier enable signal (YsaEn), an output terminal of the second pulse generation circuit 1222 is connected to a second input terminal of the latch circuit 1223, and the latch circuit 1223 outputs a precharge signal (YioEqN). In this circuit structure, signal timing is shown in FIG. 2. Herein, when in a mask write mode, Yio/YioN needs to be precharged after data read and before data write, until Yio/YioN is precharged to VCC.

To save current when in the mask write mode, a mask write flag signal (Mask Write Flag) may be introduced herein to control the precharge signal (YioEqN). Specifically, FIG. 17B is a schematic diagram 2 of a detailed structure of a control circuit according to an embodiment of the present disclosure. As shown in FIG. 17B, the control circuit may include a first pulse generation circuit 1221, a second pulse generation circuit 1222, a latch circuit 1223, a first NOT gate 1211, a first NAND gate 1213, and a second NOT gate 1214. An input terminal of the first pulse generation circuit 1221 is configured to receive RdEn, and an output terminal of the first pulse generation circuit 1221 is connected to a first input terminal of the latch circuit 1223. An input terminal of the first NOT gate 1211 is configured to receive Mask Write Flag, and an output terminal of the first NOT gate 1211 is connected to a second input terminal of the first NAND gate 1213. A first input terminal of the first NAND gate 1213 is configured to receive YsaEn, an output terminal of the first NAND gate 1213 is connected to an input terminal of the second NOT gate 1214, an output terminal of the second NOT gate 1214 is configured to output a first intermediate signal to the second pulse generation circuit 1222, an output terminal of the second pulse generation circuit 1222 is connected to a second input terminal of the latch circuit 1223, and the latch circuit 1223 outputs YioEqN.

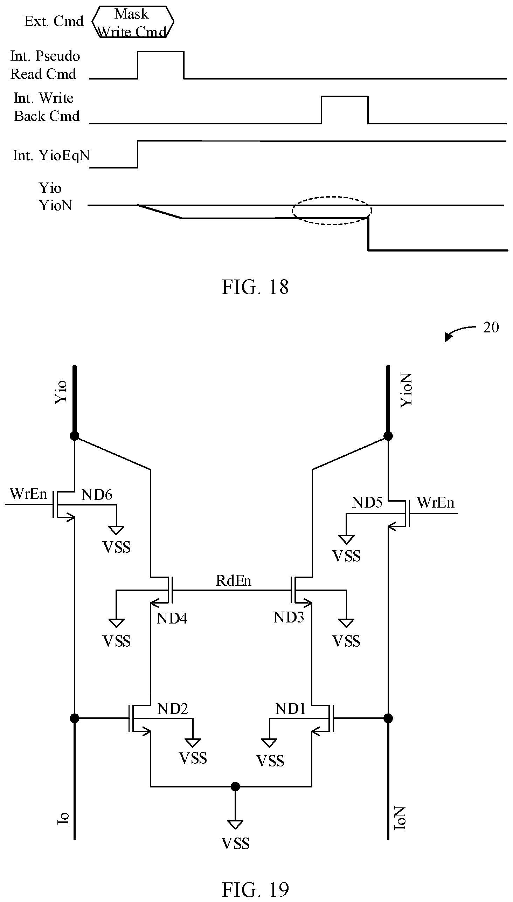

Based on the control circuit shown in FIG. 17B, signal timing may be shown in FIG. 18. Herein, a mask write operation is performed after Mask Write Cmd is received. When Int. Pseudo Read Cmd is changed from a low level state to a high level state, Int. YioEqN is also changed from the low level state to the high level state, and precharging to Yio/YioN is stopped. Yio/YioN is not precharged when Int. YioEqN continues to be in the high level state, that is, when in a mask write mode, Yio/YioN is not precharged after data read and before data write, as represented by a dashed-line circle in FIG. 18.

In addition, in this embodiment of the present disclosure, when in the mask write mode, the mask write flag signal is in the high level state (that is, Mask Write Flag="High"), so that the precharge signal is disabled (that is, Disable YioEqN), and the precharge signal between the read operation and the write operation is masked. In this case, Yio/YioN is not precharged, thereby saving current.

Further, an embodiment of the present disclosure further provides a read/write conversion circuit 20. As shown in FIG. 19, in the read/write conversion circuit 20, six NMOS transistors (ND1, ND2, ND3, ND4, ND5, and ND6) form the conversion circuit. During data read, a read enable signal (RdEn) is at a high level (logic "1"), and data on a local data line (Io) and a complementary local data line (IoN) is read to Yio and YioN, to be transmitted to a read driver circuit. During data write, a write control signal WrEn is at a high level (logic "1"), and data on Yio and YioN is written into Io and IoN, to be written into a memory cell.

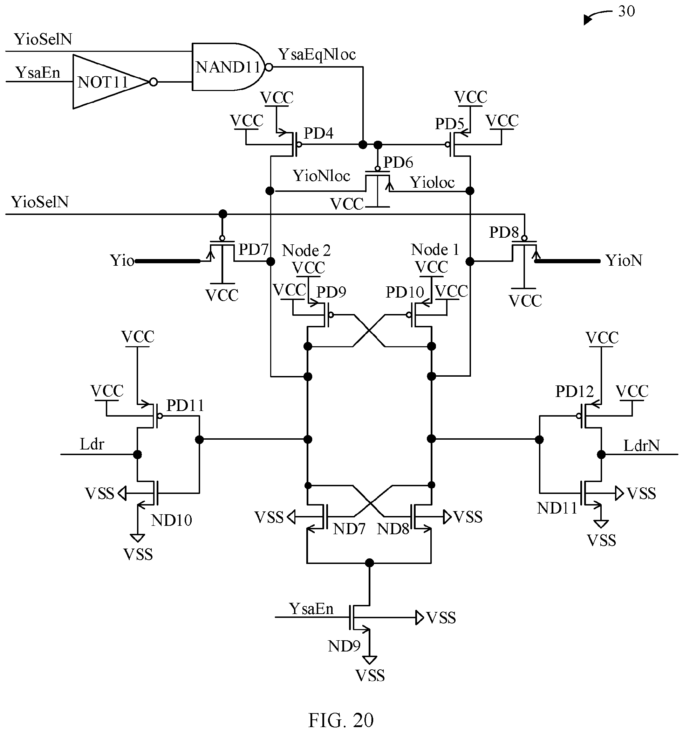

Further, an embodiment of the present disclosure further provides a read driver circuit 30. As shown in FIG. 20, in the read driver circuit 30, a NOT gate NOT11, a NAND gate NAND 11, three PMOS transistors (PD4, PD5, and PD6) form a precharge circuit, and a node 1 and a node 2 are precharged based on a read selection signal (YioSelN) and an amplifier enable signal (YsaEn). Two NMOS transistors (ND7 and ND8) and two PMOS transistors (PD9 and PD10) form a cross-coupled structure configured to perform cross-coupled amplification on signals of the node 1 and the node 2 to obtain a pair of reverse-phase signals, namely, a signal Yioloc and a signal YioNloc. YioSelN may further control the PMOS transistor PD7 and the PMOS transistor PD8 to be turned on or off, so as to control whether to transmit signals on Yio and YioN to the node 1 and the node 2. YsaEn may further control the NMOS transistor ND9 to be turned on or off, so as to control a working state of the cross-coupled structure. The NMOS transistor ND11 and the PMOS transistor PD12 form an amplifier circuit configured to amplify the signal Yioloc at the node 1 and then obtain complementary readout data LdrN. The NMOS transistor ND10 and the PMOS transistor PD11 also form an amplifier circuit configured to amplify the signal YioNloc at the node 2 and then obtain readout data Ldr.

It can be learned from the foregoing descriptions that this embodiment provides a read/write circuit. A specific implementation of the foregoing embodiment is described in detail based on the foregoing embodiment. Based on the technical solution of the foregoing embodiment, it can be learned that, when a current operation mode is the mask write mode, the control circuit controls the write driver circuit to stop precharging the data line after data read and before data write. This can save current when in the mask write mode, and can increase a data write speed when in the mask write mode, thereby improving memory performance.

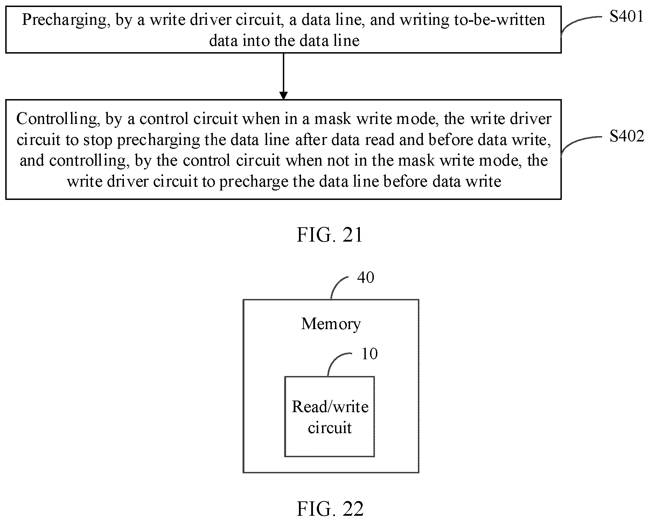

In still another embodiment of the present disclosure, FIG. 21 is a schematic flowchart of a read/write method according to an embodiment of the present disclosure. As shown in FIG. 21, the method may include the steps as follows.

In the step of S401, a data line is precharged by a write driver circuit, and to-be-written data is written into the data line.

In the step of S402, when in a mask write mode, the write driver circuit is controlled, by a control circuit, to stop precharging the data line after data read and before data write, and when not in the mask write mode, the write driver circuit is controlled, by the control circuit, to precharge the data line before data write.

It should be noted that the read/write method provided in this embodiment of the present disclosure may be applied to the read/write circuit 10 described in the foregoing embodiment.

In some embodiments, the control circuit may include a first logic circuit and a second logic circuit, and the method may further include the steps as follows.

An amplifier enable signal and a mask write flag signal are received by the first logic circuit, and a logical operation is performed on the amplifier enable signal and the mask write flag signal to generate a first intermediate signal.

A read enable signal and the first intermediate signal are received by the second logic circuit, and a logical operation is performed on the read enable signal and the first intermediate signal to generate a precharge signal.

The mask write flag signal is configured to indicate whether the read/write circuit is in the mask write mode, and the precharge signal is configured to control whether the write driver circuit precharges the data line.

In some embodiments, the write driver circuit may include a driver circuit and a precharge circuit, and the method may further include the steps as follows.

A write control signal is received by the driver circuit, and the to-be-written data is written into the data line based on the write control signal.

The precharge signal is received by the precharge circuit, and the data line is precharged based on the precharge signal.

It should be further noted that this embodiment of the present disclosure provides a read/write method, and specifically provides a control method for a global data line. The method may be a solution in which a data line is not precharged during data write when in a mask write mode, to save current. An error check and correction circuit with a global repair capability is applied to an advanced high-speed integrated circuit memory, so that Yio/YioN is not precharged after data read and before data write when in the mask write mode, thereby saving current when in the mask write mode, and further increasing a data write speed.

In yet another embodiment of the present disclosure, FIG. 22 is a schematic diagram of structural composition of a memory according to an embodiment of the present disclosure. As shown in FIG. 22, the memory 40 includes the read/write circuit 10 described in any one of the foregoing embodiments.

The memory 40 may be a static random access memory (SRAM), a dynamic random access memory (DRAM), a synchronous dynamic random access memory (SDRAM), a double data rate synchronous dynamic random access memory (DDR SDRAM), or the like. This is not specifically limited herein.

Further, in some embodiments, the memory 40 may include a DRAM chip. The DRAM chip may not only meet a memory specification such as DDR, DDR2, DDR3, DDR4, DDR5, and DDR6, but also meet a memory specification such as LPDDR, LPDDR2, LPDDR3, LPDDR4, LPDDR5, and LPDDR6. This is not specifically limited herein.

In this embodiment of the present disclosure, for the memory 40, because the memory includes the read/write circuit 10 in the foregoing embodiment, current can be saved when in a mask write mode, and a data write speed can be increased when in the mask write mode, thereby improving memory performance.

The foregoing descriptions are merely example embodiments of the present disclosure, and are not intended to limit the protection scope of the present disclosure.

It should be noted that in the present disclosure, the terms "include", "comprise", or any other variant thereof are intended to cover non-exclusive inclusion, so that a process, method, article, or apparatus that includes a series of elements includes not only those elements but also other elements that are not expressly listed, or further includes elements inherent to such a process, method, article, or apparatus. An element preceded by "includes a ..." does not, without more constraints, preclude the presence of additional identical elements in the process, method, article, or apparatus that includes the element.

The sequence numbers of the foregoing embodiments of the present disclosure are merely for the purpose of description, and are not intended to indicate priorities of the embodiments.

The methods disclosed in the several method embodiments provided in the present disclosure may be randomly combined when there is no conflict, to obtain new method embodiments.

The features disclosed in the several product embodiments provided in the present disclosure may be randomly combined when there is no conflict, to obtain new product embodiments.

The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

### Industrial applicability

In the embodiments of the present disclosure, the control circuit may determine, based on a current operation mode, whether to control the write driver circuit to stop precharging the data line. Only when the current operation mode is the mask write mode, the control circuit controls the write driver circuit to stop precharging the data line after data read and before data write. This can save current when in the mask write mode, and can increase a data write speed when in the mask write mode, thereby improving memory performance.

## Claims

1. A read/write circuit (10), comprising:
a write driver circuit (11), configured to: precharge a data line, and write to-be-written data into the data line; and
a control circuit (12), when in a mask write mode, the control circuit (12) being configured to control the write driver circuit (11) to stop precharging the data line after data read and before data write, and when not in the mask write mode, the control circuit (12) being configured to control the write driver circuit (11) to precharge the data line before data write.

2. The read/write circuit (10) according to claim 1, wherein the control circuit (12) comprises a first logic circuit (121) and a second logic circuit (122),
the first logic circuit (121) being configured to: receive an amplifier enable signal and a mask write flag signal, and perform a logical operation on the amplifier enable signal and the mask write flag signal to generate a first intermediate signal;
the second logic circuit (122) being configured to: receive a read enable signal and the first intermediate signal, and perform a logical operation on the read enable signal and the first intermediate signal to generate a precharge signal; and
the mask write flag signal being configured to indicate whether the read/write circuit (10) is in the mask write mode, and the precharge signal is configured to control whether the write driver circuit (11) precharges the data line.

3. The read/write circuit (10) according to claim 2, wherein
the read/write circuit (10) is in the mask write mode when the mask write flag signal is in a first level state, so that the precharge signal controls the write driver circuit (11) to stop precharging the data line after data read and before data write; or
the read/write circuit (10) is not in the mask write mode when the mask write flag signal is in a second level state, so that the precharge signal controls the write driver circuit (11) to precharge the data line before data write.

4. The read/write circuit (10) according to claim 2 or 3, wherein the read/write circuit (10) further comprises a read driver circuit (30),
the read driver circuit (30) being configured to amplify data on the data line, the amplifier enable signal being configured to control a power supply to provide a supply voltage to the read driver circuit (30) during data read.

5. The read/write circuit (10) according to claim 4, wherein the first logic circuit (121) comprises a first NOT gate (1211), a first NAND gate (1213), and a second NOT gate (1214),
an input terminal of the first NOT gate (1211) being configured to receive the mask write flag signal, and an output terminal of the first NOT gate (1211) being connected to a second input terminal of the first NAND gate (1213); and
a first input terminal of the first NAND gate (1213) being configured to receive the amplifier enable signal, an output terminal of the first NAND gate (1213) being connected to an input terminal of the second NOT gate (1214), and an output terminal of the second NOT gate (1214) being configured to output the first intermediate signal.

6. The read/write circuit (10) according to any one of claims 2 to 5, wherein the second logic circuit (122) comprises a latch circuit (1223),
a first input terminal of the latch circuit (1223) being configured to receive the read enable signal, a second input terminal of the latch circuit (1223) being configured to receive the first intermediate signal, and an output terminal of the latch circuit (1223) being configured to output the precharge signal.

7. The read/write circuit (10) according to claim 6, wherein the second logic circuit (122) further comprises a first pulse generation circuit (1221) and a second pulse generation circuit (1222),
an input terminal of the first pulse generation circuit (1221) being configured to: receive the read enable signal, generate a first pulse based on a rising edge of the read enable signal, and provide the first pulse to the first input terminal of the latch circuit (1223); and
an input terminal of the second pulse generation circuit (1222) being configured to: receive the first intermediate signal, generate a second pulse based on a falling edge of the first intermediate signal, and provide the second pulse to the second input terminal of the latch circuit (1223).

8. The read/write circuit (10) according to claim 7, wherein the first pulse generation circuit (1221) comprises a third NOT gate (1311), a first delay circuit (1312), and a second NAND gate (1313),
an input terminal of the third NOT gate (1311) being configured to receive the read enable signal, an output terminal of the third NOT gate (1311) being connected to an input terminal of the first delay circuit (1312), an output terminal of the first delay circuit (1312) being connected to a second input terminal of the second NAND gate (1313), a first input terminal of the second NAND gate (1313) being configured to receive the read enable signal, and an output terminal of the second NAND gate (1313) serving as an output terminal of the first pulse generation circuit (1221) and being connected to the first input terminal of the latch circuit (1223).

9. The read/write circuit (10) according to claim 7, wherein the second pulse generation circuit (1222) comprises a fourth NOT gate (1321), a second delay circuit (1322), and a first NOR gate (1323),
an input terminal of the fourth NOT gate (1321) being configured to receive the first intermediate signal, an output terminal of the fourth NOT gate (1321) being connected to an input terminal of the second delay circuit (1322), an output terminal of the second delay circuit (1322) being connected to a second input terminal of the first NOR gate (1323), a first input terminal of the first NOR gate (1323) being configured to receive the first intermediate signal, and an output terminal of the first NOR gate (1323) serving as an output terminal of the second pulse generation circuit (1222) and being connected to the second input terminal of the latch circuit (1223).

10. The read/write circuit (10) according to any one of claims 7 to 9, wherein the latch circuit (1223) comprises a third NAND gate (1331) and a fourth NAND gate (1332),
a first input terminal of the third NAND gate (1331) being connected to the output terminal of the first pulse generation circuit (1221), and a second input terminal of the third NAND gate (1331) being connected to an output terminal of the fourth NAND gate (1332); and
a first input terminal of the fourth NAND gate (1332) being connected to an output terminal of the third NAND gate (1331), a second input terminal of the fourth NAND gate (1332) being connected to the output terminal of the second pulse generation circuit (1222), and the output terminal of the third NAND gate (1331) serving as the output terminal of the latch circuit (1223) to output the precharge signal.

11. The read/write circuit (10) according to claim 3, wherein the first level state is a high level state, and the second level state is a low level state.

12. The read/write circuit (10) according to any one of claims 1 to 11, wherein the write driver circuit (11) comprises a driver circuit and a precharge circuit (113),
the driver circuit being configured to write the to-be-written data into the data line based on a write control signal; and
the precharge circuit (113) being configured to precharge the data line based on the precharge signal.

13. The read/write circuit (10) according to claim 12, wherein the driver circuit comprises a first driver circuit (111) and a second driver circuit (112), and the data line comprises a global data line (Yio) and a complementary global data line (YioN),
the first driver circuit (111) being configured to write the to-be-written data into the global data line (Yio) based on the write control signal; and
the second driver circuit (112) being configured to write the to-be-written data into the complementary global data line (YioN) based on the write control signal.

14. The read/write circuit (10) according to claim 13, wherein the first driver circuit (111) comprises a first pull-up circuit (1111) and a first pull-down circuit (1112),
the first pull-up circuit (1111) being configured to pull up a potential of the global data line (Yio) based on the to-be-written data and the write control signal; and
the first pull-down circuit (1112) being configured to pull down the potential of the global data line (Yio) based on the to-be-written data.

15. The read/write circuit (10) according to claim 14, wherein the first pull-up circuit (1111) comprises a fifth NAND gate (1514) and a first P-type transistor (P1), and the first pull-down circuit (1112) comprises a fifth NOT gate (1521) and a first N-type transistor (N1),
a first input terminal of the fifth NAND gate (1514) being configured to receive the to-be-written data, a second input terminal of the fifth NAND gate (1514) being configured to receive the write control signal, and an output terminal of the fifth NAND gate (1514) being connected to a gate terminal of the first P-type transistor (P1);
an input terminal of the fifth NOT gate (1521) being configured to receive the to-be-written data, and an output terminal of the fifth NOT gate (1521) being connected to a gate terminal of the first N-type transistor (N1); and
a second terminal of the first P-type transistor (P1) being connected to a supply voltage terminal, a second terminal of the first N-type transistor (N1) being connected to a ground terminal, and both a first terminal of the first P-type transistor (P1) and a first terminal of the first N-type transistor (N1) being connected to the global data line (Yio).

16. The read/write circuit (10) according to any one of claims 13 to 15, wherein the second driver circuit (112) comprises a second pull-up circuit (1121) and a second pull-down circuit (1122),
the second pull-up circuit (1121) being configured to pull up a potential of the complementary global data line (YioN) based on the to-be-written data; and
the second pull-down circuit (1122) being configured to pull down the potential of the complementary global data line (YioN) based on the to-be-written data and the write control signal.

17. The read/write circuit (10) according to claim 16, wherein the second pull-up circuit (1121) comprises a sixth NOT gate (1531), a seventh NOT gate (1532), and a second P-type transistor (P2), and the second pull-down circuit (1122) comprises an eighth NOT gate (1541), a third NOR gate (1542), and a second N-type transistor (N2),
an input terminal of the sixth NOT gate (1531) being configured to receive the to-be-written data, an output terminal of the sixth NOT gate (1531) being connected to an input terminal of the seventh NOT gate (1532), and an output terminal of the seventh NOT gate (1532) being connected to a gate terminal of the second P-type transistor (P2);
an input terminal of the eighth NOT gate (1541) being configured to receive the write control signal, an output terminal of the eighth NOT gate (1541) being connected to a second input terminal of the third NOR gate (1542), a first input terminal of the third NOR gate (1542) being connected to the output terminal of the sixth NOT gate (1531), and an output terminal of the third NOR gate (1542) being connected to a gate terminal of the second N-type transistor (N2); and
a second terminal of the second P-type transistor (P2) being connected to the supply voltage terminal, a second terminal of the second N-type transistor (N2) being connected to the ground terminal, and both a first terminal of the second P-type transistor (P2) and a first terminal of the second N-type transistor (N2) being connected to the complementary global data line (YioN).

18. The read/write circuit (10) according to any one of claims 12 to 17, wherein the precharge circuit (113) comprises a ninth NOT gate (1131), a tenth NOT gate (1132), a third P-type transistor (P3), a fourth P-type transistor (P4), and a fifth P-type transistor (P5),
an input terminal of the ninth NOT gate (1131) being configured to receive the precharge signal, an output terminal of the ninth NOT gate (1131) being connected to an input terminal of the tenth NOT gate (1132), an output terminal of the tenth NOT gate (1132) being connected to a gate terminal of the third P-type transistor (P3), a second terminal of the third P-type transistor (P3) being connected to the global data line (Yio), and a first terminal of the third P-type transistor (P3) being connected to the complementary global data line (YioN); and
gate terminals of both the fourth P-type transistor (P4) and the fifth P-type transistor (P5) being connected to the output terminal of the tenth NOT gate (1132), a second terminal of the fourth P-type transistor (P4) being connected to the supply voltage terminal, a first terminal of the fourth P-type transistor (P4) being connected to the global data line (Yio), a second terminal of the fifth P-type transistor (P5) being connected to the supply voltage terminal, and a first terminal of the fifth P-type transistor (P5) being connected to the complementary global data line (YioN).

19. The read/write circuit (10) according to any one of claims 1 to 18, wherein the data line comprises the global data line (Yio) and the complementary global data line (YioN), and the write driver circuit (11) comprises a second AND gate (1511), a second NOR gate (1512), a first P-type transistor (P1), a fifth NOT gate (1521), a first N-type transistor (N1), a ninth NOT gate (1131), a tenth NOT gate (1132), a third P-type transistor (P3), a sixth NOT gate (1531), a fourth NOR gate (1534), a second P-type transistor (P2), an eighth NOT gate (1541), a third NOR gate (1542), and a second N-type transistor (N2),
a first input terminal of the second AND gate (1511) being configured to receive the to-be-written data, a second input terminal of the second AND gate (1511) being configured to receive the write control signal, an output terminal of the second AND gate (1511) being connected to a first input terminal of the second NOR gate (1512), an input terminal of the ninth NOT gate (1131) being configured to receive the precharge signal, an output terminal of the ninth NOT gate (1131) being separately connected to a second input terminal of the second NOR gate (1512), an input terminal of the tenth NOT gate (1132), and a first input terminal of the fourth NOR gate (1534), an output terminal of the second NOR gate (1512) being connected to a gate terminal of the first P-type transistor (P1), an input terminal of the fifth NOT gate (1521) being configured to receive the to-be-written data, an output terminal of the fifth NOT gate (1521) being connected to a gate terminal of the first N-type transistor (N1), a second terminal of the first P-type transistor (P1) being connected to the supply voltage terminal, and a second terminal of the first N-type transistor (N1) being connected to the ground terminal;
an input terminal of the sixth NOT gate (1531) being configured to receive the to-be-written data, an output terminal of the sixth NOT gate (1531) being separately connected to a second input terminal of the fourth NOR gate (1534) and a first input terminal of the third NOR gate (1542), an output terminal of the fourth NOR gate (1534) being connected to a gate terminal of the second P-type transistor (P2), an input terminal of the eighth NOT gate (1541) being configured to receive the write control signal, an output terminal of the eighth NOT gate (1541) being connected to a second input terminal of the third NOR gate (1542), an output terminal of the third NOR gate (1542) being connected to a gate terminal of the second N-type transistor (N2), a second terminal of the second P-type transistor (P2) being connected to the supply voltage terminal, and a second terminal of the second N-type transistor (N2) being connected to the ground terminal; and
an output terminal of the tenth NOT gate (1132) being connected to a gate terminal of the third P-type transistor (P3), a first terminal of the first P-type transistor (P1), a first terminal of the first N-type transistor (N1), and a second terminal of the third P-type transistor (P3) being all connected to the global data line (Yio), and a first terminal of the second P-type transistor (P2), a first terminal of the second N-type transistor (N2), and a first terminal of the third P-type transistor (P3) being all connected to the complementary global data line (YioN).

20. A read/write method, the method comprising:
precharging, by a write driver circuit (11), a data line, and writing to-be-written data into the data line; and
controlling, by a control circuit (12) when in a mask write mode, the write driver circuit (11) to stop precharging the data line after data read and before data write, and controlling, by the control circuit (12) when not in the mask write mode, the write driver circuit (11) to precharge the data line before data write.

21. A memory (40), the memory (40) comprising the read/write circuit (10) according to any one of claims 1 to 19.
